# EUROPÄISCHE PATENTSCHRIFT

(11) **EP 1 369 993 B1**
(45) Veröffentlichungstag und Bekanntmachung des Hinweises auf die Patenterteilung: **09.11.2005**
(21) Anmeldenummer: 02360166.9
(22) Anmeldetag: 07.06.2002
(51) Int. Cl.: H03G 1/00, H03G 3/30, H03F 3/45

(54) **LVSD-Treiber in bipolarer und MOS-Technologie**
LVDS-driver in bipolar and MOS technology
Circuit d'attaque LVDS en technologie bipolaire et MOS

(43) Veröffentlichungstag der Anmeldung: 10.12.2003
(73) Patentinhaber: ALCATEL, 75008 Paris (FR)
(72) Erfinder: Ilchmann, Frank, 13158 Berlin (DE); Ballentin, Ralph, 16547 Birkenwerder (DE); Rösener, Detlef, 12683 Berlin (DE)
(74) Vertreter: Rausch, Gabriele

(56) Entgegenhaltungen:
- EP-A- 0 831 480
- US-A- 4 471 320
- US-A- 6 040 731
- US-A- 6 111 431
- VREEDE DE L C N ET AL: "A HIGH GAIN SILICON AGC AMPLIFIER WITH A 3 DB BANDWIDTH OF 4 GHZ" IEEE TRANSACTIONS ON MICROWAVE THEORY AND TECHNIQUES, IEEE INC. NEW YORK, US, Bd. 42, Nr. 4, PART 1, 1. April 1994 (1994-04-01), Seiten 546-551, XP000442444 ISSN: 0018-9480
- REIN H-M ET AL: "DESIGN CONSIDERATIONS FOR VERY-HIGH-SPEED SI-BIPOLAR IC'S OPERATINGUP TO 50 GB/S" IEEE JOURNAL OF SOLID-STATE CIRCUITS, IEEE INC. NEW YORK, US, Bd. 31, Nr. 8, 1. August 1996 (1996-08-01), Seiten 1076-1090, XP000623557 ISSN: 0018-9200

## Beschreibung

Die Erfindung betrifft eine Schaltungsanordnung für einen LVDS-Treiber (LVDS = Low Voltage Differential Signal), die eine kombinierte bipolare und MOSFET-Technologie mit mindestens zwei MOSFETs verwendet.

LVDS-Treiber (LVDS=Low Voltage Differential Signal, Differenzsignal mit niedriger Spannung) werden zum Übertragen von Daten auf symmetrischen Leitungen verwendet.

Durch die DE 199 22 354 A1 ist ein LVDS-Treiber in CMOS Technologie bekannt. Seine Geschwindigkeit wird für demnächst erforderliche Geschwindigkeiten von etwa 1 Gbit/s als zu niedrig angesehen. Außerdem benötigt die bekannte Anordnung eine positive Versorgungsspannung von 2, 5 Volt oder höher, und diese Spannung ist viel höher als der in der standardmäßigen Spezifikation für LVDS-Treiber vorgesehene Ausgangsspannungspegel von 1,2 Volt. Durch die hohe Betriebsspannung ergibt sich eine höhere Verlustleistung. Auch benötigt die bekannte Schaltung eine Nachahmungsanordnung für Regelungszwecke.

Der Erfindung liegt die Aufgabe zugrunde, eine LVDS-Treiberschaltung in integrierter Halbleitertechnologie anzugeben, die eine Erhöhung der Datenrate gegenüber dem Stand der Technik ermöglicht.

Diese Aufgabe wird gemäß der Erfindung dadurch gelöst, dass
eine Multipliziererschaltung mit einer Ausgangsstufe des LVDS-Treibers verbunden ist, und dass die Multipliziererschaltung mittels einer Regelungsschaltung gesteuert wird, die Steuersignale zum Steuern einer Stromquelle der Multipliziererschaltung und zum Steuern des Verstärkungsfaktors von differenziellen Eingangssignalen der Multipliziererschaltung erzeugt.

Vorteile der Erfindung liegen darin, dass es die genannte Technologie, bei der Halbleiterbauelemente in bipolarer Technik (z.B. NPN-und/oder PNP-Transistoren) (neben MOS-Technologie) verwendet werden, ermöglicht, von der hohen Geschwindigkeit der bipolaren Elemente im Vergleich zu MOS-Elementen Nutzen zu ziehen, wenn, wie beim Ausführungsbeispiel vorgesehen, diejenigen Teile des LVDS-Treibers, die hohe Schaltgeschwindigkeiten erfordert, in Bipolartechnik ausgeführt sind. MOS-Technik wird demgegenüber dort verwendet, wo dies aus Gründen eines hohen Eingangswiderstands zweckmäßig ist. Vorteilhaft können MOSFETs gleicher Polarität bei Ausführungsformen der Erfindung vorgesehen sein.

Es kann vorteilhaft sein gemäß einer Ausführungsform der Erfindung MOSFETs unterschiedlicher Polarität (also mindestens einen N-Kanal-MOSFET und mindestens einen P-Kanal-MOSFET) vorzusehen. Bei der unter Verwendung solcher MOSFETs zusammen mit bipolaren Elementen hergestellten integrierten Schaltung handelt es sich dann um BICMOS Technologie. Auch diese hat die genannten Vorteile der hohen Geschwindigkeit der bipolaren Elemente und der durch die MOSFETs geschaffenen Möglichkeit einer leistungsarmen Ansteuerung.

Bei Ausführungsformen ist für den LVDS-Treiber als positive Versorgungsspannung nur eine kleine Spannung von etwa 1,8 Volt unter Berücksichtigung des oben genannten Ausgangsspannungspegels erforderlich. Um Bauelemente der Schaltungsanordnung, die eine höhere Spannung benötigen, oder die im Bereich negativer Spannungen (gegenüber Masse) arbeiten müssen, verwenden zu können, ist bei Ausführungsformen der Erfindung die Anordnung so getroffen, dass zusätzlich zu der genannten positiven Versorgungsspannung für den Betrieb auch eine negative Versorgungsspannung (im Beispiel größer als die positive Versorgungsspannung) zuzuführen ist. Die Anordnung gemäß dem Ausführungsbeispiel weist außerdem mindestens einen Schaltungspunkt auf, der mit einem Massepotential zu verbinden ist, gegenüber dem die genannte positive Versorgungsspannung und negative Versorgungsspannung gemessen werden. Ein Vorteil besteht darin, dass die Ausgangsstufe oder Leistungsstufe des LVDS-Treibers, die im Vergleich zu anderen Komponenten der Schaltung einen relativ hohen Strom zur Speisung eines relativ niederohmigen Verbrauchers, nämlich eines Empfängers für die Ausgangssignale des LVDS-Treibers bereitstellen muss, wegen der kleinen Versorgungsspannung nur einen geringen Leistungsbedarf hat. Demgegenüber arbeiten die anderen Komponenten der Schaltung beim Ausführungsbeispiel mit erheblich kleineren Strömen, so dass dort eine höhere Betriebsspannung nicht zu einer unerwünschten Erhöhung der gesamten Leistung des LVDS-Treibers führt.

Bei der Ausführungsform der Erfindung nach Anspruch 4 ist von Vorteil, dass die Änderungen des Verstärkungsfaktors des Multiplizierers einfach und leistungsarm vorgenommen werden kann, und die diesen ansteuernde Schaltung wird kaum belastet. Bei dem Multiplizierer, der in dem Ausführungsbeispiel in bekannter Weise aus sechs Transistoren aufgebaut ist, liegen die Basisanschlüsse (oder allgemeiner:) Steueranschlüsse von zwei der sechs Transistoren an einer steuerbaren Spannung, und die Basisanschlüsse von zwei anderen Transistoren liegen an einer festen Spannung. Dadurch kann der Verstärkungsfaktor und somit der Multiplikationsfaktor geändert werden. Die zu verstärkenden Eingangssignale werden im Ausführungsbeispiel den Emittern der genannten Transistoren zugeführt, und an den Kollektoren erscheint das Ausgangssignal, das im Ausführungsbeispiel einer Ausgangsstufe zugeführt wird.

Bei einer Ausführungsform der Erfindung ist vorgesehen, dass die Stromquelle zur Veränderung des Offset der Ausgangsspannung des LVDS-Treibers vorgesehen ist. Im Ausführungsbeispiel erfolgt auch hier die Ansteuerung über einen MOSFET, der einen den Strom der Stromquelle steuernden weiteren Transistor ansteuert. Dieser MOSFET ist im Beispiel in einer zum Vergleich des genannten MOSFET für die Verstärkungsregelung komplementären Technologie verwirklicht.

Weitere Merkmale und Vorteile der Erfindung ergeben sich aus der nachfolgenden Beschreibung eines Ausführungsbeispiels der Erfindung anhand der Zeichnung, die erfindungswesentliche Einzelheiten zeigt, und aus den Ansprüchen. Die einzelnen Merkmale können je einzeln für sich oder zu mehreren in beliebiger Kombination bei einer Ausführungsform der Erfindung verwirklicht sein. Es zeigen:
Fig. 1 ein Blockschaltbild eines LVDS-Treibers,
Fig. 2 die Schaltung der Anordnung nach Fig. 1, und
Fig. 3 ein Blockschaltbild einer anderen Anordnung, bei der mehrere Ausgangsstufen vorhanden sind, von denen, wie in Fig. 2, das Ausgangssignal einer einzigen Ausgangsstufe von dem einzigen vorhandenen Regelungsblock geregelt wird, die Ausgangssignale weiterer Ausgangsstufen aber von dem Regelungsblock gesteuert werden.

### Schaltungsprinzip

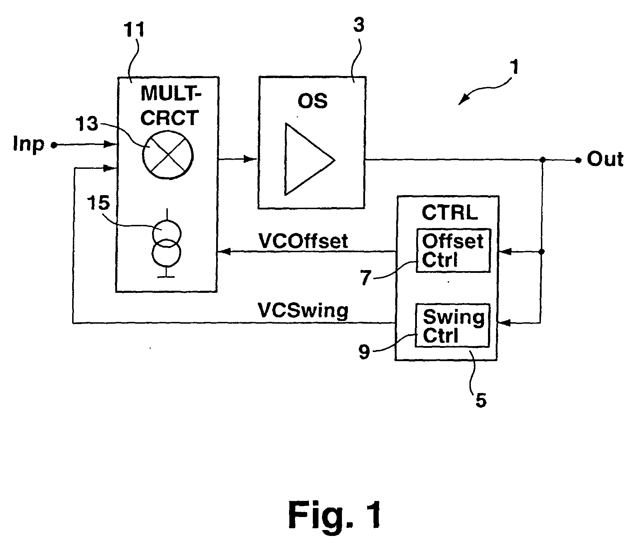

In Figur 1 weist ein LVDS-Treiber 1 eine Ausgangsstufe 3, einen Regelungsblock 5 mit zwei Regelschaltungen, nämlich einer Offsetregelung (Offset Ctrl) 7 und einer Differenzspannungsregelung (Swing Ctrl) 9, und eine Multipliziererschaltung 11 auf, die einen Multiplizierer 13 und eine steuerbare Stromquelle 15 aufweist.

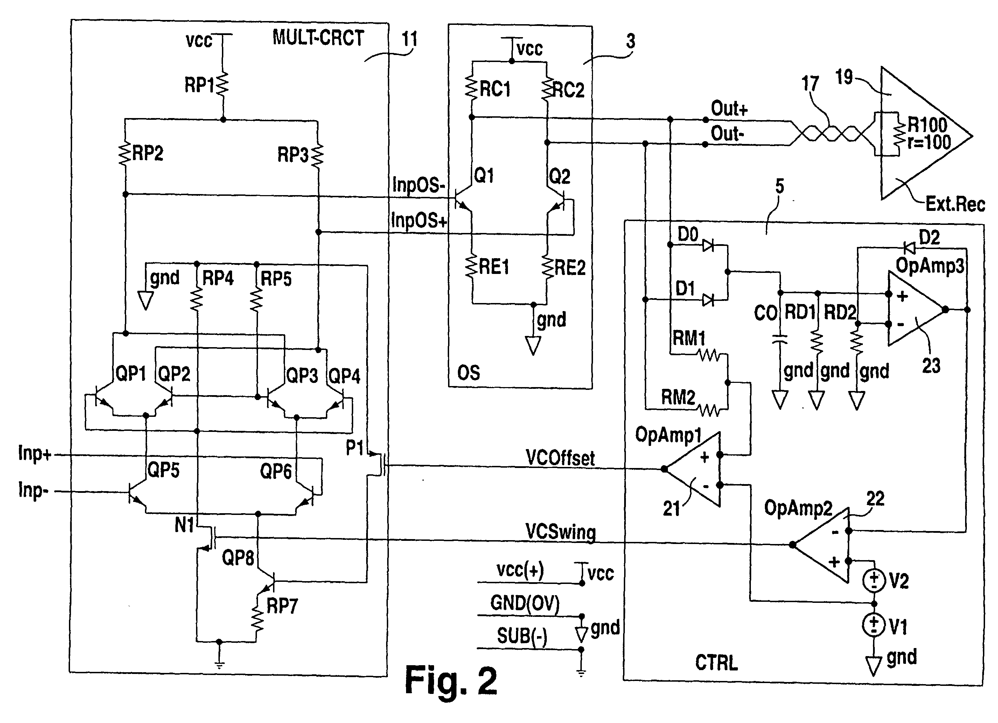

Das differentielle Ausgangssignal Out, das an Ausgängen Out+ und Out- des LVDS-Treibers 1 im Betrieb anliegt (siehe auch Fig. 2), wird dem Regelungsblock 5 zugeführt. In der Regelschaltung OffsetCtrl 7 wird der Gleichstrom-Offset des Ausgangssignals mit dem spezifizierten Offset-Referenzwert verglichen und daraus der Wert einer Steuerspannung VCOffset erzeugt. In der Regelschaltung SwingCtrl 9 wird die dynamische Aussteuerung des Ausgangssignals mit dem spezifizierten Differenzspannungs-Referenzwert verglichen und daraus der Wert einer Steuerspannung VCSwing erzeugt. Mit der Steuerspannung VCOffset wird in der Multipliziererschaltung 11 die Stromquelle 15 gesteuert und damit in der Ausgangsstufe 3 der Offset des Ausgangssignals Out nachgeführt. Mit der Steuerspannung VCSwing wird in der Multipliziererschaltung 11 der Verstärkungskoeffizient des differentiellen Eingangssignals Inp gesteuert und damit in der Ausgangsstufe 3 die Differenzspannung des Ausgangssignals Out nachgeführt. In der Ausgangsstufe 3 wird eine Leistungsverstärkung des Ausgangssignal der Multipliziererschaltung 11 durchgeführt.

Wie Fig. 2 zeigt, ist an den Ausgängen Out+ und Out- auch eine als verdrillte Zweidrahtleitung dargestellte symmetrische Leitung 17 angeschlossen, die mit einem externen LVDS-Empfänger (ExtRec) 19 mit einem Eingangswiderstand von im Beispiel 100 Ohm verbunden ist, für den das differentielle Ausgangssignal bestimmt ist.

### Erläuterung der Funktionsblöcke

Die Anordnung nach Fig. 2 enthält Halbleiterelemente (unter anderem mehrere npn-Transistoren) in bipolarer Technik sowie mehrere MOSFETs, die Anordnung ist also in bipolarer und MOS-Technologie verwirklicht.

Fig. 2 enthält komplementäre MOSFETs, es handelt sich um eine Anordnung in BiCMOS-Technologie.

Der Regelungsblock 5 (CTRL) in Fig. 2 besteht aus einer Offsetspannungsmessschaltung, einer Offsetspannungsvergleichsschaltung, einer Differenzspannungsmessschaltung und einer Differenzspannungsvergleichsschaltung. Er weist einen ersten Operationsverstärker 21 (OpAmp1), einen zweiten Operationsverstärker 22 (OpAmp2) und einen dritten Operationsverstärker 23 (OpAmp3) auf. Die Offsetspannungsmessschaltung besteht aus den Widerständen RM 1 und RM2, deren Reihenschaltung jeweils mit einem Anschluss des Differenzausgangs (Out+ und Out-) der LVDS-Treiberschaltung verbunden ist. Am gemeinsamen Knoten der Widerstände RM 1 und RM2 entsteht eine Spannung, die der Offsetspannung des differenziellen LVDS-Ausgangssignals entspricht, wenn man beide Widerstände gleich groß wählt, wie dies im Beispiel der Fall ist. Die beiden Widerstände sollten möglichst so groß gewählt werden, dass sie die Ausgangsimpedanz der LVDS-Treiberschaltung nur geringfügig beeinflussen; dies ist im Beispiel der Fall.

Der gemeinsame Knoten der Widerstände RM 1 und RM2 ist mit der Offsetspannungsvergleichsschaltung, bestehend aus dem Operationsverstärker 21 (OpAmp1), verbunden, insbesondere mit dem positiven Eingang des Operationsverstärkers OpAmp1. Der negative Eingang des Operationsverstärkers ist mit einer Offsetreferenzspannungsquelle V1 verbunden, die dem spezifizierten Offsetreferenzwert für LVDS-Treiberschaltungen entspricht und deshalb weitestgehend von Temperatur-, Betriebsspannungs- und Technologieänderungen unabhängig sein sollte; im Beispiel ist V1 eine Bandgapreferenzspannungsquelle. Am Ausgang des OpAmp1 wird die Regelspannung VCOffset erzeugt. Der Gegenkopplungspfad des OpAmp1 verläuft über die Ansteuerung der Stromquelle der Multipliziererschaltung 11 zum Ausgang der Multipliziererschaltung 11, über die LVDS-Ausgangsstufe (OS) 3 und die Offsetspannungsmessschaltung zum positiven Eingang des OpAmp1. Im eingeregelten Zustand ist die Spannung am positiven Eingang des OpAmp1, bis auf einen geringen Offsetfehler des Operationsverstärkers selbst, gleich der Spannung am negativen Eingang.

Die Differenzspannungsmessschaltung besteht aus einer Gleichrichterschaltung mit den Dioden D0 und D1, dem Widerstand RD1 und dem Kondensator C0, sowie einer speziellen Spannungsfolgerschaltung mit dem dritten Operationsverstärker OpAmp3, der Diode D2 und dem Widerstand RD2. Die Anoden der Dioden D0 und D1 sind jeweils mit dem Differenzausgang (Out+ und Out-) der LVDS-Treiberschaltung verbunden. Die Katoden dieser beiden Dioden sind miteinander, mit dem Widerstand RD 1, dem Kondensator C0 und dem positiven Eingang des Operationsverstärkers OpAmp3 verbunden, wobei RD1 und C0 parallel geschaltet sind und eine Spannungsintegrationsschaltung bilden. Der Operationsverstärker OpAmp3 ist an seinem Ausgang mit der Anode der Diode D2 verbunden, deren Katode mit dem negativen Eingang des OpAmp3 und dem Widerstand RD2 verbunden ist. Ist nun z.B. das Anodenpotential der Diode D0 auf Grund der positiven Halbwelle des LVDS-Ausgangssignals am Knoten Out+ höher als das der Diode D1 am Knoten Out-, so folgt das Katodenpotential beider Dioden dem der Diode D0. Während der negativen Halbwelle des LVDS- Ausgangssignals am Knoten Out+ befindet sich die positive Halbwelle am Knoten Out- und damit an der Anode der Diode D1, so dass das Katodenpotential beider Dioden dem der Diode D1 folgt. Dieses Potential wird über der Zeit mit Hilfe des Widerstandes RD1 und des Kondensators C0 integriert und liegt somit als pulsierende Gleichspannung am positiven Eingang des Operationsverstärkers OpAmp3 an.

Der Operationsverstärker OpAmp3 arbeitet als Spannungsfolger, wobei das Ausgangspotential eine Diodenspannung über seinem Eingangspotential liegt. Diese Diodenspannung kompensiert den Temperaturgang der Dioden D0 und D1. Unter der Voraussetzung, dass sowohl die Dioden D0, D1 und D2 als auch die Widerstände RD1 und RD2 gleich groß und vom gleichen Typ sind, erhält man am Ausgang des Operationsverstärkers annähernd die halbe Differenzspannung des LVDS-Ausgangssignals. Der Ausgang des Operationsverstärkers OpAmp3 ist mit der Differenzspannungsvergleichsschaltung, bestehend aus dem Operationsverstärker OpAmp2, verbunden, insbesondere mit dem negativen Eingang des Operationsverstärkers OpAmp2. Der positive Eingang des Operationsverstärkers ist mit einer Amplitudenreferenzspannungsquelle V2 verbunden, die der spezifizierten Offsetreferenzspannung plus dem halben spezifizierten Ausgangsamplitudenreferenzwert für LVDS- Treiberschaltungen entspricht und deshalb weitestgehend von Temperatur-, Betriebsspannungs- und Technologieänderungen unabhängig sein sollte; V2 ist daher als Bandgapreferenzspannungsquelle realisiert. Am Ausgang des OpAmp2 wird die Regelspannung VCSwing erzeugt.

Der Gegenkopplungspfad des OpAmp2 verläuft über die Ansteuerung eines Steuereinganges der Multipliziererschaltung 11zum Ausgang der Multipliziererschaltung 11, über die LVDS-Ausgangsstufe 3 und die Differenzspannungsmessschaltung zum negativen Eingang des OpAmp2. Im eingeregelten Zustand ist die Spannung am negativen Eingang des OpAmp2, bis auf einen geringen Offsetfehler des Operationsverstärkers selbst, gleich der Spannung am positiven Eingang.

Die Regelstrecke der in Fig. 2 dargestellten Schaltungsanordnung enthält eine regelbare Verstärkerstufe und eine einzige Ausgangsstufe 3. Die Ausgangsstufe 3 stellt mit den Transistoren Q1/Q2, den Widerständen RC1/RC2 und RE1/RE2 zwei Kollektorstufen dar. (Der Buchstabe "C" in den Widerstandsbezeichnungen "RC.." ist keinerlei Hinweis auf einen Kondensator.)

Die regelbare Verstärkerstufe besteht aus einem Vierquadranten-Steilheitsmultiplizierer (Gilbert Zelle), gebildet im Wesentlichen durch sechs Transistoren QP1 bis QP6, und aus der steuerbaren Stromquelle15, die im Wesentlichen durch einen Transistor QP8 und einen Widerstand RP7 gebildet wird.

Das differentielle Dateneingangssignal wird an den Knoten Inp+ bzw. Inp- der beiden unteren Transistoren QP5 bzw. QP6 des Vierquadranten Steilheitsmultiplizierers angelegt. Die Transistoren QP5 und QP6 bilden einen Differenzverstärker. Die Kollektoren dieser Transistoren funktionieren als Ausgänge von zwei Stromquellen, die durch das differentielle Dateneingangssignal 180 Grad phasenversetzt zueinander arbeiten.

Der Gesamtstrom des regelbaren Verstärkers wird durch die regelbare Stromquelle 15 bereit gestellt. Diese besteht aus Transistor QP8, dessen Emitter über Widerstand RP7 gegengekoppelt ist. Das Basispotential an QP8 wird über den Transistor P1 bereitgestellt dessen Eingang durch die Regelspannung VCOffset gesteuert wird.

Die Transistoren QP1, QP2, QP3 und QP4 sind die eigentlichen Stellglieder des regelbaren Verstärkers. Die Eingänge von QP1/QP4 bzw. QP2/QP3 sind zusammengefasst und dienen als Steuereingänge des regelbaren Verstärkers. Die Kollektoren von QP2/QP4 sind an Kollektorwiderstand RP3 und die Kollektoren von QP1/QP3 sind an Kollektorwiderstand RP2 angeschlossen. Die an die Widerstände RP2 und RP3 angeschlossenen Kollektoren bilden die Ausgänge der Multipliziererschaltung und liefern gegenphasige Signale (Gegentaktsignal oder differentielles Signal) auf einem Niveau größer als Null Volt an die Eingänge der Ausgangsstufe 3. RP1 dient zur Spannungsabsenkung, um eine Sättigung der Kollektoren der Transistoren Q1 und Q2 in der Ausgangsstufe 3 zu verhindern und verbessert das dynamische Verhalten der Ausgangsstufe 3.

Der Steuereingang am Transistorpaar QP2/QP3 hat über Widerstand RP5 ein festes Potential. Das Potential am Steuereingang des Transistorpaares QP1/QP4 wird durch einen veränderlichen Spannungsteiler, bestehend aus Widerstand RP4 und Transistor N1, bereitgestellt. Das Teilerverhältnis des Spannungsteilers wird durch die Regelspannung VCSwing bestimmt.

### Erläuterung der Funktion

### Regelung der Offsetspannung

Angenommen, die Offsetspannung am LVDS-Treiber-Ausgang wird auf Grund äußerer Einflussfaktoren (z.B. Temperatur- und/oder Betriebspannungsänderungen) positiver als sie spezifiziert worden ist, so wird diese Spannungsänderung über den gemeinsamen Knoten der Widerstände RM 1 und RM2 an den positiven Eingang des OpAmp1 geleitet. Hier entsteht gegenüber der Offsetreferenzspannung eine positive Spannungsdifferenz. Diese Spannungsdifferenz führt zu einer positiven Änderung der Regelspannung VCOffset am Ausgang des OpAmp1. Daraufhin wird der PMOS-Transistor P1 im Multiplizierer auf Grund seiner etwas kleineren Gate-Source-Spannung hochohmiger, was zu einem geringeren Basisstrom für den NPN-Transistor QP8 führt, der wiederum einen geringeren Kollektorstrom in QP8 zur Folge hat. Durch die Verringerung des Gesamtstromes im Multiplizierer durch den Transistor QP8 steigt die Offsetspannung an den Widerständen RP2 und RP3 und damit am Eingang der LVDS-Ausgangsstufe 3 mit den Knoten InpOS+ und InpOS- an. Der Anstieg der Basispotentiale der Transistoren Q1 und Q2 und damit der Spannungsabfall über den Widerständen RE1 und RE2, die als einfache Stromquelle für die Ausgangsstufe 3 dienen, führt zu einem höheren Strom durch die Widerstände RE1/RE2 und RC1/RC2 in der Ausgangstufe, wodurch sich die Offsetspannung an den Knoten Out+ und Out- verringert.

### Regelung der Amplitude

Nimmt man einmal beispielhaft eine Erhöhung der Amplitude des differentiellen LVDS-Ausgangssignals auf Grund äußerer Einflussfaktoren, wie Temperatur und/oder Betriebspannungsänderungen (auch eine geringe Änderung des LVDS-Leitungsabschlusswiderstandes durch Austausch der LVDS- Empfangsschaltung ist denkbar), an, so wird diese Amplitudenänderung über die Dioden D0 und D1 zu einer Erhöhung des Potentials am positiven Eingang des Operationsverstärkers OpAmp3 führen. Über die Diode D2 erhält man daraufhin am Ausgang des OpAmp3 und damit am negativen Eingang des Operationsverstärkers OpAmp2 ein Potential, das der halben erhöhten Amplitude des differentiellen LVDS-Ausgangssignals entspricht. Am negativen Eingang des OpAmp2 entsteht gegenüber der Amplitudenreferenzspannung eine positive Spannungsdifferenz. Diese Spannungsdifferenz führt zu einer negativen Änderung der Regelspannung VCSwing am Ausgang des OpAmp2. Die geringere Spannung VCSwing am Gate des NMOS-Transistors (N-Kanal-MOSFETs) N1 im Multiplizierer verursacht daraufhin einen höheren Innenwiderstand des Transistors und als Folge dessen eine höhere Drain-Source-Spannung Vds von N1.

Durch den Wert der Regelspannung am Eingang QP1/QP4 gegenüber der Festspannung am Eingang QP2/QP3 wird der Stromfluss durch diese Transistoren bestimmt. Je nach Steuerspannung am Eingang QP1/QP4 findet eine Addition der 180 Grad phasenversetzten Ströme durch QP2 und QP4 bzw. durch QP1 und QP3 statt. Dadurch kann die Spannungsamplitude an RP2 und RP3 verändert werden. Ist die Spannung an den beiden Steuereingängen gleich, ist die Summe der Teilströme zu jedem Zeitpunkt gleich und damit die Verstärkung 0. Sind beide Spannungen an den Steuereingängen ungleich, ist die Verstärkung ungleich 0.

Dabei darf die Spannung am Steuereingang QP1/QP4 nie kleiner als die Spannung am Steuereingang QP3/QP4 werden, da sonst eine Phasendrehung des Datensignals erfolgt. Dies wird durch eine geeignet Dimensionierung verhindert.

Durch das etwas erhöhte Potential am Eingang QP1/QP4 gegenüber der Festspannung am Eingang QP2/QP3 verringert sich die Differenzspannung an diesem Eingang des Multiplizierers und damit der Multiplikationsfaktor, was zu einer Verringerung der Spannungsamplitude an den Widerständen RP2 und RP3 und folglich auch zur Verringerung der Amplitude am Ausgang der L VDS-Treiberschaltung führt, da diese eine fest eingestellte Verstärkung hat.

Die ganze Schaltung wird durch eine positive Versorgungsspannung VCC und eine negative Versorgungsspannung SUB, an der das Substrat der integrierten Halbleiterschaltung liegt, gespeist. Außerdem ist ein zwischen diesen beiden Versorgungsspannungen liegendes Massepotential GND an mehrere Punkte der Schaltung angelegt.

In der erfindungsgemäßen Schaltung fließt in der Ausgangsstufe 3 (nur bipolare Technik) der größte Teil des aufgenommenen Gesamtstroms der Schaltung (etwa 10mA von 12mA). Um die Verlustleistung zu reduzieren, wird die Ausgangstufe nur mit der niedrigen positiven Betriebsspannung VCC von 1,8 Volt betrieben, die nur geringfügig höher ist als die spezifizierte Ausgangsspannung von 1,2 Volt. Die negative Betriebsspannung SUB beträgt 3,2 Volt. Daher ist die gesamte Betriebsspannung der Multiplizierschaltung 5 Volt. Die Operationsverstärker werden mit - 3,2 Volt gespeist. Daraus ergibt sich eine typische Verlustleistung von etwa 30mW (1,8V*10mA+5V*2mA) der ganzen Schaltung nach Fig. 1 und Fig. 2. Insgesamt sind als wichtige Vorteile zu nennen: Hohe Datenbitrate von etwa bis zu 1 Gbit/s, kleiner Leistungsverbrauch; kleine positive Versorgungsspannung für die Anordnung, insbesondere für die Ausgangsstufe; Integration auf einem einzigen Chip. Dabei können auf dem Chip zusätzlich logische Schaltungen untergebracht sein, deren Ausgangssignal den Eingängen Inp+ und Inp- zugeführt wird. Die Ausgangssignale solcher logischer Schaltungen befinden sich häufig auf einem Niveau unterhalb von Null Volt. Die Schaltung nach Fig. 2 kann diese Signale als Eingangssignale verarbeiten (wegen der negativen Betriebsspannung SUB) und ein Ausgangssignal liefern, das sich, wie für LVDS spezifiziert, insgesamt auf einem Niveau oberhalb von Null Volt befindet.

Wenn aus der Anordnung nach Figur 1 der Regelungsblock 5 entfernt wird, so bleibt eine Schaltungsanordnung übrig, die lediglich eine Pegelanpassung und eine Anpassung insofern, dass ein relativ niederomiger Verbraucher (der mit der Ausgangsstufe zu verbindende Empfänger) gespeist werden müssen, ausführt. Diese Schaltungsanordnung federt daher sozusagen die Eingangsspannung gegenüber der Belastung durch den Empfänger ab und wird daher mit dem Wort Buffer (für Puffer) bezeichnet.

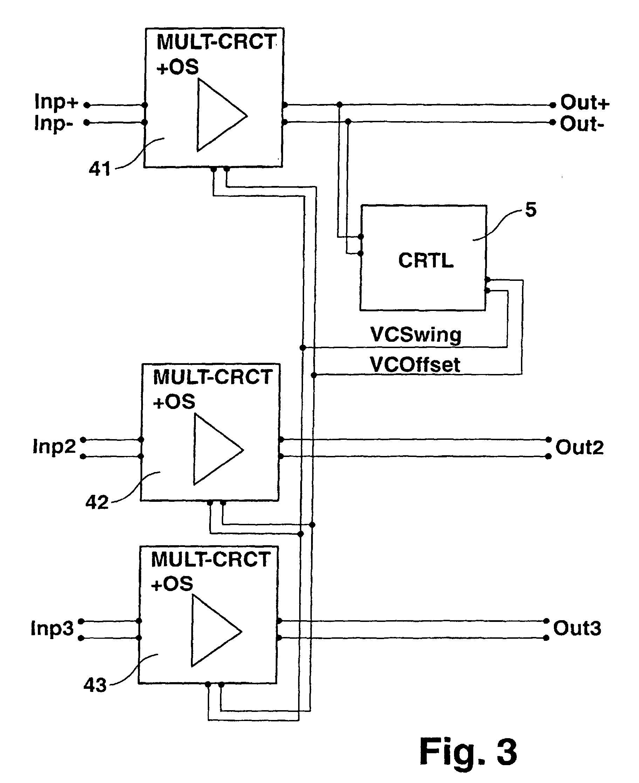

Gemäß Figur 3 läßt sich die anteilige Verlustleistung der Regelschaltung 5 pro LVDS-Buffer dadurch reduzieren, indem zusätzlich zu dem in Fig. 2 gezeigten Buffer, der in Fig. 3 mit dem Bezugszeichen 41 bezeichnet ist, weitere LVDS-Buffer 42 und 43 von der Regelschaltung 5 des ersten Buffers 41 mitgesteuert (nicht geregelt) werden. Diese Anschaltung der weiteren Buffer ist ohne Änderungen möglich, weil die Regeleingänge VCSwing und VCOffset auf Gates von MOSFETs geführt sind und dadurch kein Eingangsstrom fließt. Im Beispiel sind die weiteren Buffer 42 und 43 in einer integrierten Schaltung, die eine Anordnung nach Fig. 2 enthält, mit enthalten. Sie können statt dessen separat angeordnet sein.

Eine solche Anordnung kann problemlos insbesondere dann eingesetzt werden, wenn alle zu speisenden Empfänger sich sehr ähnlich verhalten, insbesondere von identischem Aufbau sind, und dann, wenn bei einer zu berücksichtigenden Temperaturabhängigkeit der Empfänger, diese Empfänger sich etwa alle auf der selben Temperatur wie der Empfänger, der mit dem geregelten Buffer in Verbindung steht, befinden. Diese Voraussetzungen sind im allgemeinen dann vorhanden, wenn sich die verschiedenen Empfänger innerhalb des gleichen Geräts vorzugsweise auf der gleichen Schaltungsplatte oder Platine befinden. Dabei ist mit maximalen gegenseitigen Entfernungen von beispielsweise etwa 30 cm zu rechnen.

Zur weiteren Erhöhung der Regelverstärkung und daher der Regelgenauigkeit ist bei einer anderen Ausführungsform die Ausgangsstufe als stromgegengekoppelte Differenzstufe ausgeführt, indem die Emitter der Transistoren Q1 und Q2 verbunden sind.

Eine weitere Reduzierung der Verlustleistung wird erreicht, indem der Vorgabewert des Amplituden-Referenzwertes soweit reduziert wird, dass der spezifizierte Amplitudenwert von 250mV unter allen Technologie- und Umweltbedingungen noch eingehalten wird. Dies wird insbesondere durch die vorhandene Regelung unterstützt.

Die Anordnung nach Figur 2 ist in BiCMOS-Technologie als integrierte Schaltung verwirklicht. Es sind nämlich bipolare Transistoren, sowie mindestens ein N-Kanal-MOSFET (Transistor N1) und mindestens ein P-Kanal-MOSFET (Transistor P1) vorhanden. Statt dessen könnten auch für die dort vorhandenen MOSFETs zwei gleichpolare MOSFETs (zwei mit N-Kanal oder zwei mit P-Kanal) vorgesehen sein. In diesem letztgenannten Fall muss die konkrete Schaltung im allgemeinen modifiziert werden, zum Beispiel muss derjenige MOSFET, der nun in einer anderen Polarität vorgesehen werden soll, in dem Stromweg, den er steuert, an einen anderen Platz verlagert werden. Im Vergleich zu der Anordnung nach Figur 2 kann es auch erforderlich sein, die Polarität eines der von dem Regelungsblock kommenden Steuersignale umzukehren. Im Fall von gleichpolaren MOSFETs handelt es sich dann um eine Schaltung in kombinierter bipolarer und MOSFET-Technologie. Auch bei dieser modifizierten Schaltungsanordnung ist der Vorteil der geringen Leistungsaufnahme wegen der Verwendung von MOSFETs vorhanden, so dass sich auch diese Anordnung für eine Parallelschaltung von "Buffern" analog zur Figur 3 prinzipiell eignet.

Alle genannten Transistoren mit Ausnahme der MOSFETs (N1, P1) sind in bipolarer Technik verwirklicht.

## Patentansprüche

1. Schaltungsanordnung für einen LVDS-Treiber, die eine kombinierte bipolare und MOSFET-Technologie mit mindestens zwei MOSFETs verwendet,
**dadurch gekennzeichnet, dass**
eine Multipliziererschaltung (11) mit einer Ausgangsstufe (3) des LVDS-Treibers (1) verbunden ist, und dass die Multipliziererschaltung mittels einer Regelungsschaltung (5) gesteuert ist, die Steuersignale zum Steuern einer Stromquelle der Multipliziererschaltung und zum Steuern des Verstärkungsfaktors von differenziellen Eingangssignalen der Multipliziererschaltung erzeugt.

2. Schaltungsanordnung nach Anspruch 1, **dadurch gekennzeichnet, dass** die Ausgangsstufe für die Speisung ausschließlich durch eine erste Betriebsspannung gegenüber Masse ausgebildet ist, und dass mindestens eine weitere Komponente der Schaltung zur Speisung mit Hilfe einer zweiten, gegenüber der ersten Betriebsspannung gegenpoligen Betriebsspannung ausgebildet ist.

3. Schaltungsanordnung nach Anspruch 2, **dadurch gekennzeichnet, dass** die Multipliziererschaltung (11) zur Speisung gleichzeitig durch die erste und die zweite Betriebsspannung ausgebildet ist.

4. Schaltungsanordnung nach Anspruch 1, **dadurch gekennzeichnet, dass** die Steuersignalausgänge der Regelungsschaltung (5) mit je einem Eingang eines MOSFET gekoppelt sind, wobei einer der genannten MOSFETs zur Steuerung der Stromquelle ausgebildet ist, und der andere MOSFET zur Steuerung des Verstärkungsfaktors des Multiplizierers ausgebildet ist.

5. Schaltungsanordnung nach Anspruch 1, **dadurch gekennzeichnet, dass** die Stromquelle zur Veränderung des Offset der Ausgangsspannung des LVDS-Treibers vorgesehen ist.

6. Schaltungsanordnung nach Anspruch 1, **dadurch gekennzeichnet, dass** die Multipliziererschaltung zur Lieferung zweier gegenphasiger zu verstärkender Signale an die Ausgangsstufe ausgebildet ist.

7. Schaltungsanordnung nach Anspruch 6, **dadurch gekennzeichnet, dass** die Ausgangsstufe bipolare Transistoren enthält, die jeweils zur Verstärkung eines der Ausgangssignale des Multiplizierers ausgebildet sind.

8. Schaltungsanordnung nach Anspruch 1, **dadurch gekennzeichnet, dass** die Regelungsschaltung eine Einrichtung zum Ermitteln einer von der Spannungsdifferenz zwischen von der Ausgangsstufe gelieferten differentiellen Signalen abhängigen Steuersignals und eine Einrichtung zum Erzeugen eines vom Offset der Ausgangssignale der Ausgangsstufe abhängigen Steuersignals ausgebildet ist.

## Claims

1. Circuit arrangement for an LVDS driver which uses combined bipolar and MOSFET technology with at least two MOSFETs, **characterised in that** a multiplier circuit (11) is connected to an output stage (3) of the LVDS driver (1) and the multiplier circuit is controlled by means of a closed-loop control circuit (5) which generates control signals for controlling a current source of the multiplier circuit and for controlling the amplification factor of differential input signals of the multiplier circuit.

2. Circuit arrangement according to claim 1, **characterised in that** the output stage for the feeding is constructed exclusively by a first operating voltage against earth and at least one further component of the circuit for feeding is constructed with the aid of a second operating current with opposite polarity to the first operating voltage.

3. Circuit arrangement according to claim 2, **characterised in that** the multiplier circuit (11) for feeding is constructed simultaneously by the first and the second operating voltage.

4. Circuit arrangement according to claim 1, **characterised in that** the control signal outputs of the closed-loop control circuit (5) are coupled to an input of a MOSFET in each case, wherein one of said MOSFETs is constructed for controlling the current source and the other MOSFET is constructed for controlling the amplification factor of the multiplier.

5. Circuit arrangement according to claim 1, **characterised in that** the current source is provided for changing the offset of the output voltage of the LVDS driver.

6. Circuit arrangement according to claim 1, **characterised in that** the multiplier circuit is constructed for delivering to the output stage two opposite-phase signals to be amplified.

7. Circuit arrangement according to claim 6, **characterised in that** the output stage contains bipolar transistors which are constructed in each case for amplifying one of the output signals of the multiplier.

8. Circuit arrangement according to claim 1, **characterised in that** the closed-loop control circuit is constructed as a device for detecting a control signal dependent on the voltage difference between differential signals delivered by the output stage and a device for generating a control signal dependent on the offset of the output signals of the output stage.

## Revendications

1. Arrangement de circuit pour un étage amplificateur LVDS qui emploie une technologie combinée bipolaire et MOSFET avec au moins deux MOSFET, **caractérisé en ce qu'**un circuit multiplicateur (11) est relié avec un étage de sortie (3) de l'étage amplificateur LVDS (1) et que le circuit multiplicateur est commandé au moyen d'un circuit de régulation (5) qui génère des signaux de commande pour commander une source de courant du circuit multiplicateur et pour commander le facteur d'amplification des signaux d'entrée différentiels du circuit multiplicateur.

2. Arrangement de circuit selon la revendication 1, **caractérisé en ce que** l'étage de sortie est conçu pour être alimenté exclusivement par une première tension de sortie par rapport à la masse et qu'au moins un composant supplémentaire du circuit est configuré pour être alimenté à l'aide d'une deuxième tension de service dont la polarité est l'inverse de celle de la première tension de service.

3. Arrangement de circuit selon la revendication 2, **caractérisé en ce que** le circuit multiplicateur (11) est configuré pour être alimenté simultanément par la première et la deuxième tension de service.

4. Arrangement de circuit selon la revendication 1, **caractérisé en ce que** les sorties signal de commande de l'arrangement de circuit de régulation (5) sont à chaque fois connectées à une entrée d'un MOSFET, l'un desdits MOSFET étant configuré pour commander la source de courant et l'autre MOSFET étant configuré pour commander le facteur d'amplification du multiplicateur.

5. Arrangement de circuit selon la revendication 1, **caractérisé en ce que** la source de courant est prévue pour modifier l'offset de la tension de sortie de l'étage amplificateur LVDS.

6. Arrangement de circuit selon la revendication 1, **caractérisé en ce que** le circuit multiplicateur est configuré pour délivrer à l'étage de sortie deux signaux en opposition de phase à amplifier.

7. Arrangement de circuit selon la revendication 6, **caractérisé en ce que** l'étage de sortie contient des transistors bipolaires qui sont à chaque fois configurés pour amplifier l'un des signaux de sortie du multiplicateur.

8. Arrangement de circuit selon la revendication 1., **caractérisé en ce que** le circuit de régulation est réalisé sous,la forme d'un dispositif destiné à déterminer un signal de commande dépendant de la différence de tension entre les signaux différentiels délivrés par l'étage de sortie et d'un dispositif destiné à générer un signal de commande dépendant de l'offset des signaux de sortie de l'étage de sortie.
